# EUROPÄISCHE PATENTSCHRIFT

(11) **EP 0 830 642 B1**
(45) Veröffentlichungstag und Bekanntmachung des Hinweises auf die Patenterteilung: **28.07.1999**
(21) Anmeldenummer: 96929287.9
(22) Anmeldetag: 21.08.1996
(51) Int. Cl.: G03F 7/42, H05K 3/26

(54) **VERFAHREN ZUM FILMSTRIPPEN**
FILM-STRIPPING PROCESS
PROCEDE DE DETACHEMENT DE FILMS

(30) Priorität: 23.08.1995 DE 19530989
(43) Veröffentlichungstag der Anmeldung: 25.03.1998
(73) Patentinhaber: ATOTECH Deutschland GmbH, 10553 Berlin (DE)
(72) Erfinder: BARON, David, T., Worchestershire DY12 1QF (GB); SCHNEIDER, Reinhard, D-90556 Cadolzburg (DE)
(74) Vertreter: Effert, Bressel und Kollegen
(86) Internationale Anmeldenummer: EP9603662
(87) Internationale Veröffentlichungsnummer: WO9708589

(56) Entgegenhaltungen:
- EP-A- 0 254 550
- EP-A- 0 547 488
- DE-A- 3 002 732
- DE-A- 3 201 880
- DE-U- 8 401 675

## Beschreibung

Die Erfindung betrifft ein Verfahren zum gleichmäßigen chemischen Ablösen von Schichten von Resisten, insbesondere von Photoresisten, in Form leicht filtrierbarer Teilchen von den Oberflächen von plattenförmigem Galvanisiergut, beispielsweise Leiterplatten und Leiterfolien, mittels eines Lösungsmittels sowie zum Entfernen des abgelösten Resists aus dem Lösungsmittel.

In der Leiterplattentechnik dienen Resiste zur Abdeckung von nicht zu behandelnden Oberflächen. Hierzu werden beispielsweise Photoresiste und Siebdrucklacke verwendet.

Bei der Herstellung von Leiterplatten werden unter anderem folgende Prozeßschritte durchgeführt:
- Laminieren der auf der gesamten Oberfläche mit Kupfer metallisierten und gegebenenfalls durchkontaktierten Platten mit einem festen oder flüssigen Photoresist, auch Film genannt. Hierbei handelt es sich in der Regel um ein lichtempfindliches quellbares Polymer.
- Belichten des Filmes durch eine Maske, die das Leiterbild je nach verwendetem Leiterplattenprozess positiv oder negativ wiedergibt.
- Entwickeln des Filmes. Die nicht belichteten Stellen werden dabei vom Film befreit. Die übrigen Stellen verbleiben als harte und haftfeste Schicht auf der Behandlungsgutoberfläche.
- Galvanisieren der nicht mit Film bedeckten Oberflächen beim Leiterbildaufbau, und zwar mit Kupfer und anschließend mit Zinn oder einer Zinn/Blei- Legierung als Ätzresist.
- Filmstrippen. Hierbei wird der Resistfilm mit einem wäßrigen Lösungsmittel von den Oberflächen abgelöst und dabei vollständig entfernt.
- Ätzen der Kupferschichten, die vom Film abgedeckt waren.
- Abätzen der Ätzresistschichten aus Zinn oder derZinn/ Blei-Legierung.

Das Filmstrippen wird vorzugsweise in horizontalen Durchlaufanlagen auf chemischem Wege durchgeführt. Dabei werden die zu behandelnden Oberflächen mit der wäßrigen Lösung eines Lösungsmittels angesprüht und angespritzt. Ein verbreitetes Mittel zum Filmstrippen ist Natronlauge. Femer sind hierzu wäßrige Lösungen bekannt, die beispielsweise Aminoverbindungen oder ionische Stickstoffverbindungen sowie alkalische oder erdalkalische Hydroxide sowie Mischungen dieser Verbindungen enthalten. Beim Strippen soll der Film möglichst nur abgelöst und nicht aufgelöst werden, denn ein in der Lösung aufgelöster Film läßt sich nicht mehr ausfiltern. Daraus würden sich entsprechende Entsorgungsprobleme und insbesondere eine kurze Standzeit des Bades ergeben. Daher wird der Film hierzu in einem ersten Verfahrensschritt zunächst angelöst und danach abgelöst. Der Verfahrensschritt des Ablösens, der auch als Quellschritt bezeichnet wird, sowie der Ablösevorgang werden in einem gemeinsamen Bad mit mehreren Sprüh- und / oder Spritzregistern durchgeführt.

Bei den bekannten Verfahren treten folgende Nachteile auf:
- Die Konzentration des Lösemittels muß so gewählt werden, daß die Lösung den Film in einer akzeptablen Zeit anlöst, ihn jedoch beim nachfolgenden Ablösen nicht zu stark auflöst. Dieser Widerspruch ist nur mit einem Kompromiß lösbar. Bei zu langer Behandlungszeit geht ein Teil des Filmes in Lösung, so daß er mit Filtem nicht mehr entfernt werden kann. Bei zu kurzer Behandlungszeit wird der Film von den Oberflächen nicht vollständig entfernt.
- Zum Quellen wird eine lange Sprühzeit benötigt, weil durch das Sprühen oder Spritzen keine große aktive Flüssigkeitsmenge an die Oberflächen gefördert werden kann. Es besteht kein inniger Kontakt der Lösung mit dem zu quellenden Film.
- Der Film wird durch intensives Spritzen mit hohem Druck von den Leiterplattenoberflächen abgelöst. Dabei wird jedoch der Film in kleine Bruchstücke zerschlagen. Diese Stücke lösen sich wegen ihrer großen Oberfläche schneller auf. Mechanisch wirkende Filter zur Entfernung des abgelösten Filmes aus der Lösung sind für den aufgelösten Anteil des Filmes unwirksam. Die Standzeit eines derartigen Filmstrippbades ist deshalb unzureichend.
- Zur Vermeidung einer Schaumbildung beim Sprühen und Spritzen müssen der wäßrigen Lösung Antischaummitel zugegeben werden. Durch Verwendung dieser Mittel stellen sich mehrere Nachteile ein:
   - Das Antischaummittel bildet eine zähflüssige, klebrige Emulsion, die sich an den Wänden des Arbeitsbehälters und auf den Transportwalzen absetzt.
   - Von den Transportwalzen wird die klebrige Emulsion sporadisch auf die Oberfläche des Behandlungsgutes aufgerollt. Nachfolgende Prozesse werden dadurch beeinflußt. Bisweilen treten Fehler beim Strippen der Zinn/Blei-Legierung auf. Die klebrige Emulsion wird insbesondere zwischen sehr feine Leiterzüge haftfest eingedrückt. Zur Enffernung der Verunreinigungen wird versucht, die Oberflächen mit höherem Druck anzuspritzen. Dies ist mit mäßigem Erfolg allerdings nur bei Leiterplatten möglich. Leiterfolien sind bei Spritzbehandlung schwer zu transportieren. Bei hohem Spritzdruck, beispielsweise bei 10 Bar, können Leiterfolien nicht mehr transportiert werden, oder es sind so viele Führungselemente nötig, daß die Folienoberflächen nicht ausreichend zugänglich sind.
   - Antischaummittel sind polymere Mittel, die aus Kunststoffwerkstoffen der Behälter und Transportrollen die Weichmacher herauslösen. Deshalb müssen die Anlagen aus Edelstahl hergestellt werden. Deren Herstellkosten sind etwa doppelt so hoch wie entsprechende Anlagen aus Kunststoff.
- Durch das Sprühen und Spritzen wird ständig Luft in die Lösungen eingetragen. Dadurch laufen unerwünschte chemische Reaktionen ab:
   - Durch die Luft wird Sauerstoff und Kohlendioxid in das basische Lösungsmittel eingetragen. Lauge reagiert damit zu Carbonat. Beispielsweise bildet sich aus Natronlauge Natriumcarbonat. Unterstützt wird diese Reaktion durch die erhöhte Arbeitstemperatur, die etwa 60°C bis 65°C beträgt. Das gebildete Carbonat kann vom Lösungmittel jedoch nicht mehr wirtschaftlich abgetrennt werden. Bei erhöhtem Carbonatgehalt ist die Wirksamkeit des Lösungsmittels reduziert. Die Strippgeschwindigkeit nimmt mit zunehmenden Carbonatgehalt ab, so daß die Standzeit des Bades verringert wird.
   - Der beim Spritzen in die Filmstripperlösung eingetragene Sauerstoff reagiert mit dem Zinn der Zinn- oder Zinn/Blei-Legierungsschicht zu Zinnstein (SnO(OH) ₓ). Der Zinnstein verursacht folgende Probleme:
      - Er setzt sich bei höheren Temperaturen an den für diese Temperaturen benötigten Edelstahlbehälterwänden so haftfest ab, daß er praktisch nicht mehr zu entfernen ist.
      - Zinnstein lagert sich auch auf den von Film befreiten Kupferflächen ab. Die damit bedeckten Flächen sind in der nachfolgenden Kupferätzlösung nicht oder nur unvollständig ätzbar.
      - Der Zinnstein bildet sich auch auf den Zinn- bzw. Blei/Zinn-Ätzresistschichten der Leiterbahnen. Deshalb ist beim späteren Entfernen des Ätzresistes eine längere Behandlung dieser Fehlstellen erforderlich. Dies führt außerhalb der Fehlstellen zu einem unerwünschten Abtrag der Kupferleiterbahnen.

   - Durch das Spritzen werden zusätzlich anlagentechnische Probleme verursacht:
   - Durch das Spritzen ist es mit einfachen Mitteln nicht möglich, das Lösemittel des Quellers vom Lösemittel des Ablösebereiches getrennt zu halten. Dies hätte Vorteile für die Standzeit der Quellerlösung. Nur im Ablösebereich fällt der durch mechanische Mittel zu trennende Film an, der sich im Queller allerdings schnell auflöst. Ferner könnte mit unterschiedlichen Konzentrationen des Lösemittels, die genau an die jeweilige Prozeßstufe angepaßt sind, gearbeitet werden. Durch die Spritzregister werden jedoch die Lösungen beider Bereiche vermischt. Verstärkt wird dieser negative Effekt dann, wenn es Probleme bei der vollständigen Entfernung von Resist aus übergalvanisierten Stellen (pilzförmige Überwucherungen über die Resistschichten) sowie von haftfesten Verunreinigungen, wie oben beschrieben, gibt. In diesem Falle muß mit einem größeren Spritzdruck, beispielsweise von 10 Bar oder mehr, gearbeitet werden. Die Folge ist ein noch größeres Ineinanderspritzen und Vermischen der Quellerlösung mit der nachfolgenden Lösung zum Ablösen der Resistschichten. Die in den bekannten Anlagen getrennte Kreislaufführung zur Trennung beider Lösungen wird dadurch weitgehend zunichte gemacht. Hierbei gelangen abgelöste Film partikel auch in den Quellerbereich. Sie lösen sich dort auf und verringern damit die Standzeit auch dieser Lösung ganz wesentlich. Unterschiedliche Konzentrationen der Lösungen sind nicht aufrechtzuerhalten.
   - Durch das Spritzen wird der sichere Transport von Leiterfolien durch die Horizontalanlage gefährdet. Zu diesen Folien zählen insbesondere auch die Innenlagen von Multilayern. Die Innenlagen haben einen bedeutenden Produktionsanteil, d.h. ihre Produktion muß kostengünstig und sicher erfolgen, was mit der Spritztechnik nur unzureichend möglich ist.
- Insgesamt ist die Standzeit des Filmstrippers unzureichend. Sie beträgt etwa eine Woche bis zu einem Monat.
- Das Verfahren verursacht große Abwassermengen.

In der Druckschrift DE 32 01 880 A1 ist ein Verfahren zum rückstandsfreien Entschichten von Leiterplatten offenbart, bei dem die zu entschichtende Leiterplatte mit einer alkalischen Lösung kurzzeitig kontaktiert und vor dem Einsetzen des chemischen Lösungsprozesses einer Kontaktierung mit erwärmten Wasser unterworfen wird. Hierdurch sollen die Resistschichten nur angelöst und anschließend in mehr oder weniger großen Partikeln oder Fladen abgelöst werden. Zur Durchführung des Verfahrens werden die zu behandelnden Leiterplatten in vertikaler Lage durch eine Vorrichtung bewegt, wobei die Behandlungsflüssigkeiten durch Schlitzdüsen, die parallel zum Transportweg in der Nähe der oberen Leiterplattenkanten angeordnet sind, auf die Leiterplattenoberfläche gefördert werden und von dort an den Oberflächen herabrinnen. Dadurch können jedoch die benötigten Behandlungsflüssigkeiten nicht gleichmäßig an die Leiterplattenoberflächen herangebracht werden. Außerdem wird die Durchflutung von Löchern in den Leiterplatten behindert, da die an einer Oberfläche herabgleitende Flüssigkeit den Durchtritt der Flüssigkeit von der anderen Seite behindert und umgekehrt. Ferner ist der Transport von Folien in einer derartigen Anlage unmöglich.

Schließlich wird vorgeschlagen, zum Ablösen der Resistschichten auch Bürsten oder feststehende Wischblätter einzusetzen, da ohne diese offensichtlich keine sichere Resistentfernung möglich ist. Diese Bürsten setzen sich schnell mit dem klebrigen Resist voll; an den Wischerblättem bleibt der abgelöste Resist haften. Dadurch wird deren Wirksamkeit beeinträchtigt. Außerdem können die Leiterplattenoberflächen durch diese mechanische Behandlung leicht beschädigt werden.

In der Druckschrift DE 30 11 061 A1 ist ein Verfahren zur Intensivierung von Spül- und Reinigungsprozessen für Leiterplatten offenbart, bei dem die Leiterplatten über eine in Spülkammem befindliche Spülmittelschwallstrecke geführt werden, wobei die Schwallstrecke unterhalb der Transportbahn für die Leiterplatten aus mindestens einem Schlitzrohr besteht, aus dem das Spülmittel austritt.

Nach einer anderen Druckschrift, DE 39 16 694 A1, können derartige Schwallstrecken ebenfalls zur Reinigung und chemischen Behandlung von Leiterplatten eingesetzt werden, wobei in der dort offenbarten Anordnung zusätzlich auf der einen Seite der Leiterplatten und der Schwallstrecke gegenüberliegend eine Saugstrecke vorgesehen ist.

Allerdings sind in diesen beiden Druckschriften keine Hinweise auf die Entschichtung von Leiterplatten und die Abtrennung des abgelösten Resists von dem verwendeten Lösungsmittel sowie die hierfür erforderlichen Maßnahmen enthalten.

Vielmehr wird mit den offenbarten Verfahren und Vorrichtungen bezweckt, die in den Leiterplatten vorgesehenen Löcher möglichst wirksam zu durchströmen, um einen guten Stoffaustausch zu gewährleisten. Dies spielt jedoch bei der Entschichtung von Leiterplatten keine wesentliche Rolle, da die Resiste ausschließlich auf den Leiterplattenaußenseiten aufgebracht werden und daher auch von dort entfernt werden müssen.

Die Entwicklung der Filmstrippanlagen wurde allerdings mit zunehmender Feinleitertechnik immer weiter in Richtung zum Hochdruckspritzen vorangetrieben.

Der vorliegenden Erfindung liegt von daher das Problem zugrunde, die Nachteile des Standes der Technik zu vermeiden und insbesondere eine lange Standzeit der Behandlungsbäder zu gewährleisten sowie weitgehend abwasserfrei den in Form leicht filtrierbarer Teilchen abgelösten Film zur kostengünstigen Entsorgung separieren zu können. Ferner sollen durch das gleichmäßige Filmstrippen die nachfolgenden Prozesse wie Ätzen des Kupfers und Zinn/Blei-Strippen nicht störend beeinflußt werden. Schließlich sollen durch das Verfahren geringe Anlagenlängen und Prozeßzeiten ermöglicht werden.

Das Problem wird gelöst durch das Verfahren und die Vorrichtung gemäß den Patentansprüchen 1 und 13. Vorteilhafte Ausführungsformen der Erfindung sind in den Unteransprüchen angegeben.

Es hat sich gezeigt, daß entgegen der bisherigen Ansicht, Hochdruckspritzanlagen könnten insbesondere die Probleme beim Entschichten von Feinleiterplatten bewältigen, beruhigte Flüssigkeitsströmungen, die in innigen Kontakt mit dem zu entfernenden Film auf der Leiterplatte stehen, wesentlich bessere Ergebnisse und weitere anlagentechnische Vorteile ermöglichen. Allerdings hat es sich auch gezeigt, daß es nicht ausreicht, die Leiterplatten nur zu fluten. Hier ist der Flüssigkeitsaustausch an der Diffusionsschicht viel zu gering. Erst die Verwendung von Schwalldüsen, die große Flüssigkeitsmengen fördern, brachte den erwünschten Erfolg. Durch Einsatz dieser Düsen werden die beschriebenen Nachteile der Spritzdüsen und die durch sie verursachten Folgen vermieden. Es wird kein oder nur noch sehr wenig Antischaummittel benötigt. Der Lufteintrag in die Lösungen entfällt nahezu vollständig. Wegen der grundsätzlich besseren Wirksamkeit des Gesamtprozesses kann auf hohe Arbeitstemperaturen verzichtet werden. Dies erlaubt die Verwendung von Kunststoffbehältern wie zum Beispiel aus Polypropylen.

Das erfindungsgemäße Verfahren arbeitet ohne Spritzdüsen. Es hat sich herausgestellt, daß die bekannten Sprüh- und Spritzprozesse weniger wirksam sind als Prozeßschritte mit beruhigter Flüssigkeitsanströmung. Unter beruhigter Flüssigkeitsanströmung soll eine Behandlung mit großen, mäßig fließenden Flüssigkeitsmengen mit niedrigem Überdruck, bei der die Düsen nahe am Behandlungsgut angeordnet sind, verstanden werden. Das Schwallen aus Schwalldüsen stellt hierfür ein Beispiel dar. Unter Schwalldüsen sollen solche langgestreckten Düsen verstanden werden, die eine große Menge von Behandlungsflüssigkeit mit geringem Überdruck als ununterbrochenen Schwall gegen die Oberfläche des Behandlungsgutes fördern. Der Querschnitt des Schwalles ist in Abhängigkeit von der Breite des Längsschlitzes der Düse im Vergleich zur Spritzdüse groß. Das so erzeugte Schwallprofil wird auch als stehende Welle bezeichnet. Als wirksam zum Quellen und Ablösen des Filmes erweist sich eine langgestreckte Schwalldüse, wie sie in der Schrift DE 35 28 575 A1 beschrieben ist. Sie ist zur Förderung großer Flüssigkeitsmengen geeignet. So können zum Beispiel bei einer Düsenlänge von 700 mm ca. 7 m³ Flüssigkeit pro Stunde durchgesetzt werden. Ein Teil der Flüssigkeit gelangt durch die Löcher der Leiterplatte an ihre gegenüberliegende Seite. Somit wirkt die Schwalldüse an der Leiterplatte beidseitig. Auf diese Weise wird zwischen Flüssigkeit und Leiterplattenoberfläche ein intensiver Kontakt hergestellt, ohne daß Flüssigkeit in benachbarte Behandlungsbäder gespritzt wird.

Das Galvanisiergut, vorzugsweise Leiterplatten und Leiterfolien, wird durch geeignete Transportmittel in horizontaler Lage und horizontaler Richtung in einer Transportebene durch mehrere hintereinander angeordnete Behandlungsstationen transportiert. Mindestens in den Behandlungsstationen, in denen die Resistschichten angequollen und abgelöst werden, sind mindestens eine langgestreckte, quer zur Transportrichtung sowie parallel und in geringem Abstand zur Transportebene angeordnete Schwalldüse vorgesehen. Mittels dieser Schwalldüsen werden die Behandlungsflüssigkeiten gegen die Leiterplattenoberfläche als Schwall gefördert.

Die Schwalldüsen können einander gegenüberliegend oder versetzt zueinander angeordnet werden. Diese Düsen erstrecken sich vorzugsweise quer zur Transportrichtung der Leiterplatten und über die gesamte Arbeitsbreite der Durchlaufanlage. Unterhalb von oberen Schwalldüsen können sich auf der gegenüberliegenden unteren Seite der Leiterplatte in geringem Abstand zur Leiterplatte Auffangbehälter für die durch die Leiterplattenlöcher gelangende Behandlungsflüssigkeit befinden. Dies fördert die beidseitige Wirkung auch der oberen Schwalidüsen an den Leiterplattenoberflächen.

Es hat sich als besonders vorteilhaft herausgestellt, die Düsen jeweils mit mindestens einer Druckkammer und einer daneben angeordneten Saugkammer zu versehen, die jeweils mindestens einen Schlitz aufweisen, und deren Schlitze sich zur gleichen Seite des Galvanisiergutes öffnen. Dadurch wird eine stärkere Strömung parallel zur Leiterplattenoberfläche erreicht.

Die Resistschichten werden zunächst in einer ersten Behandlungsstation mittels eines Quellmittels angequollen. In der nachfolgenden Behandlungsstufe werden diese in Form leicht filtrierbarer Teilchen mittels eines Ablösemittels abgelöst. Als Behandlungsflüssigkeit wird in allen Prozeßstufen des erfindungsgemäßen Verfahrens die wäßrige Lösung eines Lösemittelkonzentrats eingesetzt. Die Zudosierung des Lösemittelkonzentrates erfolgt nur in die erste Behandlungsstation, in der die Behandlungsflüssigkeit als Quellmittel eingesetzt wird. Deshalb sind die Konzentrationen von Bad zu Bad unterschiedlich. Durch einen Überlauf und durch die Ausschleppung des Behandlungsgutes gelangt die Behandlungsflüssigkeit auch in die zweite Behandlungsstation, in dem sich das Ablösemittel für die Resistschichten befindet. Die dritte Prozeßstufe, die im wesentlichen ein erstes Spülen mit Wasser darstellt, wird durch die Ausschleppung aus der zweiten Behandlungsstation mit Ablösemittel nachgeschärft. Filterrückläufe des Ablösemittels können bedarfsweise in alle drei Prozeßstufen vollständig oder teilweise geleitet werden. Somit läßt sich in allen Prozeßstufen eine individuelle Lösemittelkonzentration einstellen und halten. Durch geeignete Flüssigkeitsführung der Behandlungsflüssigkeiten wird die Vermischung der beiden Mittel weitgehend vermieden. Ein unkontrolliertes Spritzen der Flüssigkeiten von einem Bad zum anderen findet daher nicht statt. Die Lösungen werden durch die bekannten Walzen, beispielsweise Abquetschwalzen, und Wehre in den Arbeitsräumen der Horizontalanlage sowie durch getrennte Auffang- und Vorratsbehälter und durch getrennte Kreislaufführungen sicher und nahezu vollständig getrennt. Es verbleibt nur die Ausschleppung. Durch diese Trennung wird im wesentlichen nur das Bad zur Filmablösung mit dem abgelösten Polymer belastet, was zur Standzeiterhöhung des dreistufigen Gesamtprozesses beiträgt.

Nachfolgend werden die einzelnen Behandlungsstufen beschrieben:

### Erste Prozeßstufe, Quellen:

Der Quellprozeß wird mit einem Quellmittel, das die höchste Konzentration des Lösemittels aufweist, betrieben. Die Lösung steht mit der Leiterplattenoberfläche über den beschriebenen Schwall in einem intensiven Kontakt. Die Lösung wird dort in einer großen Menge an der Oberfläche immer wieder schnell durch frische Lösung ausgetauscht. Der Film wird, von der Oberfläche beginnend, gequollen und angelöst, jedoch nicht aufgelöst. Die Konzentration sowie die Einwirkzeit sind darauf abgestimmt. Durch das schnelle Quellen entstehen in dem zunächst harten Film durch Volumenzunahme innere Spannungen, die sich beim nachfolgenden Ablösen des Filmes von der Oberfläche unterstützend auswirken.

Walzen quer zur Transportrichtung an der Ober- und Unterseite der Leiterplatte zwischen dem Quellprozeß und dem Ablöseprozeß sprengen den unter der inneren Spannung stehenden Film zumindest teilweise vom Untergrund ab.

### Zweite Prozeßstufe, Ablösen:

Die Konzentration des Lösemittelkonzentrats in dem Ablösemittel wird so eingestellt, daß bei gegebener Einwirkzeit ein Auflösen des Filmes weitgehend unterbleibt. Das Ablösen und gegebenenfalls Absaugen des Filmes mit dem mit Resist angereicherten Ablösemittel mit einer Druck- oderDruck-/Saugschwalldüse erfolgt überwiegend vollflächig. Der Film wird dabei nicht in kleine Splitter zerschlagen. Im allgemeinen ist je Seite der Leiterplatte eine versetzt angeordnete Schwalldüse ausreichend. Infolgedessen werden kurze Anlagenlängen ermöglicht. Das vollflächige Ablösen und die eingestellte Chemikalienkonzentration verhindert ein schnelles Auflösen des abgelösten Filmes in der wäßrigen Lösung. Eine Auflösung wäre gleichbedeutend mit einem hohem Chemikalienverbrauch, das heißt einer kurzen Standzeit.

Von der zweiten Behandlungsstation gelangt das beladene Ablösemittel in einen Separator. Dieser kann zum Beispiel aus einem schräg gestellten Sieb bestehen. Mittels des Separators wird der Film vom Lösungsmittel getrennt. Das vom Film befreite Ablösemittel wird der Anlage wieder zugeführt. Um ein Auflösen des Resists in dem Ablösemittel zu vermeiden, wird das Ablösemittel so schnell wie möglich durch Wahl kurzer Förderwege und hoher Strömungsgeschwindigkeiten in den Separator gepumpt.

Die Trennung des Resists aus der Lösung kann auch zweistufig erfolgen. Ein zusätzliches Feinfilter im Filterrücklauf oder einem eigenen Filterkreislauf sorgt für das Entfernen von kleinsten Filmpartikeln. Dieses nahezu vollständige Entfernen des Filmes aus der Behandlungslösung führt dazu, daß die Standzeit des Gesamtprozesses sehr groß wird. Versuchsergebnisse deuten auf eine Standzeit von bis zu einem Jahr hin. Der in den Filtern abgetrennte Film soll zur kostengünstigen Entsorgung möglichst trocken und an der Oberfläche chemikalienfrei zurückgewonnen werden. Dies geschieht durch ein kontinuierliches oder periodisches Ausschwemmen des separierten Filmes aus einer Sammelkammer des Separators in ein nachgeschaltetes Filter. Das periodische Ausschwemmen des Filters erfolgt zum Beispiel alle 5 - 60 Minuten. Das zum Ausschwemmen verwendete Wasser kann der Spülkaskade entnommen und dorthin zurückgeführt werden. Insbesondere wenn es sich bei dem Filter zum Abtrennen des Spülwassers vom Film um eine Zentrifuge handelt, fällt der Film nahezu trocken an.

### Dritte Prozeßstufe, Nachbehandeln:

Der nicht immer erforderliche Nachbehandlungsprozeß wird mit einer schwachen Konzentration des Lösemittelkonzentrats oder nur mit angereichertem Spülwasser durchgeführt. Dieser Prozeß dient als Sicherheitsstufe zur Entfernung von Filmresten, die beim Ablöseprozeß nicht erfaßt werden. Grundsätzlich ist auch hier der Einsatz von Schwalldüsen möglich. Als wirksamer erwies sich jedoch das Fluten. In einem Flutraum wird die Leiterplatte beidseitig und zur Vermeidung eines Lufteintrages unterhalb des Badspiegels intensiv mit der Flüssigkeit angeströmt. Durch diese mechanische Unterstützung werden mögliche Filmreste von den Oberflächen entfernt. Die schwache Konzentration erlaubt eine längere Behandlungszeit ohne Gefahr der Auflösung der Filmreste.

Die Düsen zur Erzeugung der mechanischen Ablösung durch Strömung an die Leiterplatten werden im Kreislauf mit der Behandlungsflüssigkeit gespeist. Als sehr wirksam haben sich Düsen erwiesen, die unterhalb des Badspiegels neben einer intensiven Strömung auf hydrodynamischen Wege Kavitationsblasen erzeugen. Bei der Implosion dieser Blasen an den Oberflächen der Leiterplatten entstehen Zug- und Druckkräfte, die das Entfernen von Filmresten unterstützen. Eine derartige Düse ist in der deutschen Offenlegungsschrift 24 33 653 beschrieben. Durch das beidseitig gleichmäßige Anströmen des Behandlungsgutes unterhalb des Badspiegels ist es auch möglich, Leiterfolien sicherer zu transportieren. Der Nachbehandlungsprozeß entspricht einer Spüle beziehungswiese Chemiespüle. Bedarfsweise kann die Lösung der dritten Behandlungsstation über einen Feinseparator gefiltert werden. Dieser Chemiespüle schließen sich weitere Spülen an. Sie sind zweckmäßigerweise als Kaskaden ausgebildet. Die Anzahl der Spülkaskaden wird so groß gewählt, daß die Menge des den Spülkaskaden kontinuierlich zugegebenen Spülwassers den Verlusten der Behandlungsflüssigkeiten in den Behandlungsstationen durch Verdunstung sowie durch Ausschleppung beim Transport des Galvanisiergutes von einer Behandlungsstation zur nächsten und zu den Spülkaskaden, abzüglich der Menge zudosierter Prozeßchemikalien, entspricht. An die Nachbehandlungsstation schließt sich eine Trocknungsstation an.

Die beschriebenen drei Prozeßstufen weisen folgende Merkmale auf:
1. Prozeßstufe, Quellen:
   Starker Stoffaustausch an den Oberflächen durch intensives Schwallen. Wenig mechanische Unterstützung erforderlich.
2. Prozeßstufe, Ablösen:
   Geringer Stoffaustausch an den Oberflächen durch Schwalldüsen. Stärkere mechanische Unterstützung durch Schwalldüsen mit Druck- und Saugwirkung.
3. Prozeßstufe, Nachbehandeln:
   Geringer Stoffaustausch an den Oberflächen oder kein Stoffaustausch durch Fluten. Starke mechanische Unterstützung durch intensives Anströmen und durch Kavitation.

Der gesamte Filmstrippprozeß läßt sich in einer 5-fachen Spülkaskade abwasserfrei führen. Die in Transportrichtung des Behandlungsgutes letzte Spülkaskade wird mit Frischwasser gespeist. Die zugeführte Menge deckt die Verdunstungsverluste, einschließlich der im Trockner verdunsteten Flüssigkeit, sowie die Ausschleppung mit dem abgelösten Film. Die Behandlungsflüssigkeit wird mit Chemikalien fortlaufend ergänzt. Die Chemikalien werden in die erste Prozeßstufe zudosiert. Von hier gelangen die Chemikalien in die nachfolgenden Prozeßstufen mit entsprechend niedrigeren Konzentrationen. Durch Steuerung der Flüssigkeitsüberläufe sowie durch Filterkreislaufführung wird ein Gleichgewicht der Konzentrationen in den einzelnen Prozeßstufen erreicht. Dies führt zu hohen Standzeiten des Gesamtprozesses und zur weitgehenden Abwasserfreiheit. Mit geeigneten Filtern läßt sich der abgelöste, jedoch noch nicht aufgelöste Film vom Ablösemittel nahezu vollständig trennen und fast trocken zur Entsorgung zurückgewinnen. Auch dies trägt zur Reduzierung der Kosten des Gesamtprozesses bei.

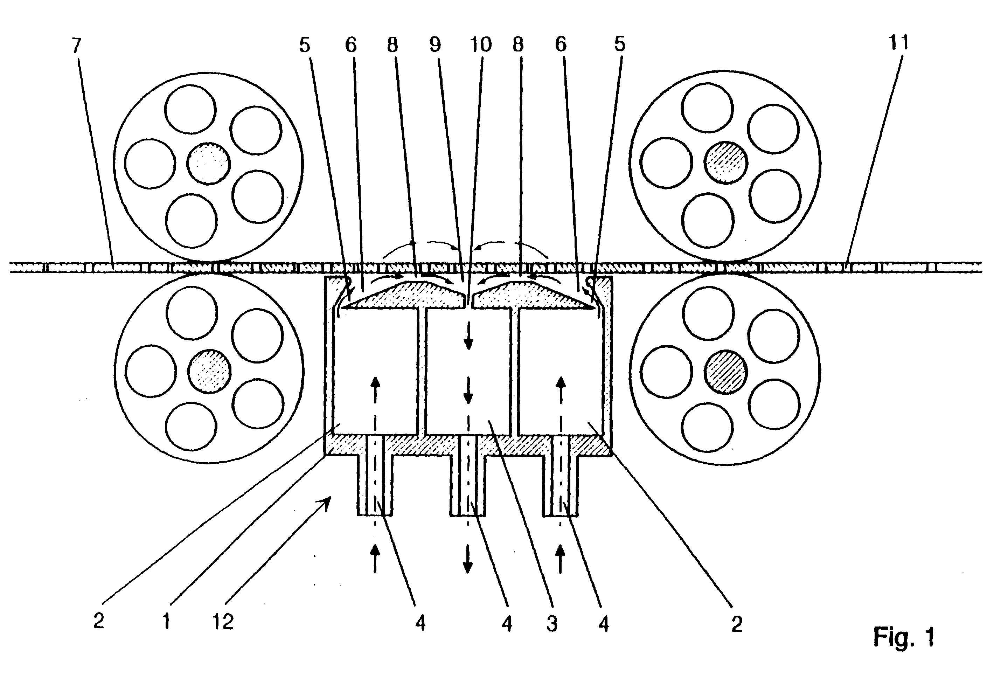

Zur weiteren Erläuterung der Erfindung dient Figur 1.

Der vorzugsweise aus Kunststoff bestehende, mehrteilige Schwalldüsenkörper 1 ist in Fig. 1 im Querschnitt dargestellt. Er besteht aus zwei Druckkammern 2 und einer Saugkammer 3. Die Kammern haben Rohranschlüsse 4 zum Anschluß an eine drückende und an eine saugende Pumpe. Die Pumpen fördern aus einem beziehungsweise in einen gemeinsamen Auffangbehälter. Zur gleichmäßigen Flüssigkeitsverteilung in den Kammern der Schwalldüse können entlang des Düsenkörpers mehrere Rohranschlüsse 4 angebracht sein. Die Druckkammern 2 können untereinander durch Rohre verbunden sein. Die in die Kammern 2 einströmende Behandlungsflüssigkeit tritt durch die schräggestellten Längsschlitze 5 als Schwall aus. Die Pfeile deuten dies an. In den vorgelagerten Aussparungen 6 entsteht jeweils ein Flüssigkeitsüberdruck, wenn sich Behandlungsgut 7 in geringem Abstand vor der Druck-/Saugschwalldüse 12 befindet. Die Düse 12 weist mit den Schlitzen 5,10 versehene Flächen 6,8 auf, die als konisch beidseitig zu den Schlitzen sich erstreckende Ebenen 6,8 ausgebildet sind, derart, daß zwischen den Schlitzen und der Transportebene, in der das Galvanisiergut transportiert wird, Aussparungen 6,9 entstehen. Durch die Aussparung 8, die mit dem Behandlungsgut einen Kanal bildet, strömt die Flüssigkeit in die Aussparung 9 des Saugbereiches. Ein weiterer Längsschlitz 10 erlaubt den Durchtritt in die Saugkammer 3. Dem Überdruck in den Aussparungen 6 steht der Unterdruck in der Aussparung 9 gegenüber. Der Überdruck fördert durch die Löcher 11 der Leiterplatte auch Behandlungsflüssigkeit an die der Düse gegenüberliegende Seite. Der saugende Teil der Schwalldüse 12 holt diese Flüssigkeit durch die Löcher wieder zurück. Ein geringer Teil der Flüssigkeit geht aus diesem Kreislauf verloren. Es gelangt drucklos in einen gemeinsamen Auffangbehälter zurück. Die Druck- und Saugwirkung dieser Düse kompensiert sich so, daß zusammen mit dem Flüssigkeitspolster zwischen Leiterplatte und Düse auch Folien sicher behandelt werden können. Zur Vereinfachung kann der Düsenkörper 1 auch mit nur einer Druckkammer 2 ausgeführt sein. In diesem Fall entfällt die mittlere Kammer 3, so daß wieder eine symmetrische Druck-/Saugschwalldüse mit vorzugsweise schräggestellten Längsschlitzen 5 entsteht. Eine der ursprünglichen Druckkammern wird zur Saugkammer.

## Patentansprüche

1. Verfahren zum gleichmäßigen chemischen Ablösen von Schichten von Resisten, insbesondere von Photoresisten, in Form leicht filtrierbarer Teilchen von den Oberflächen von plattenförmigem Galvanisiergut, beispielsweise Leiterplatten und Leiterfolien, mittels eines Ablösemittels sowie zum Entfernen des abgelösten Resists aus dem Lösungsmittel mit folgenden wesentlichen Merkmalen:
- Transportieren des Galvanisiergutes in horizontaler Lage und horizontaler Richtung durch eine Behandlungsanlage,
- Quellen der Resistschichten mittels eines Quellmittels als Behandlungsflüssigkeit in einer ersten Behandlungsstufe,
- Führen des Quellmittels und des Ablösemittels in einem Filterkreislauf, wobei die Vermischung der beiden Mittel durch geeignete Flüssigkeitsführung weitgehend vermieden wird und
- Abtrennen des abgelösten Resists vom Ablösemittel mittels eines hierfür geeigneten Separators,
dadurch gekennzeichnet, daß die Oberseite und die Unterseite des Galvanisiergutes mit Behandlungsflüssigkeiten mittels langgestreckter, im wesentlichen senkrecht zur Transportrichtung und parallel zu den Galvanisiergutoberflächen ausgerichteter Düsen derart in Kontakt gebracht werden, daß die Behandlungsflüssigkeiten zur mechanischen Ablösung der Resiste durch Strömung als Flüssigkeitsschwall gegen die Galvanisiergutoberflächen gefördert werden.

2. Verfahren nach Anspruch 1, dadurch gekennzeichnet, daß die Galvanisiergutoberflächen durch vollständiges Eintauchen in Wasser oder in eine Mischung eines Lösemittels mit Wasser als Nachbehandlungsmittel in einer dritten Behandlungsstufe nach dem Ablösen des Resists nachbehandelt werden.

3. Verfahren nach einem der vorstehenden Ansprüche, dadurch gekennzeichnet, daß das Nachbehandlungsmittel an die Galvanisiergutoberflächen gefördert wird.

4. Verfahren nach Anspruch 1, dadurch gekennzeichnet, daß hydrodynamisch Kavitationsblasen innerhalb des an die Galvanisiergutoberflächen geförderten Nachbehandlungsmittels gebildet werden.

5. Verfahren nach einem der vorstehenden Ansprüche, dadurch gekennzeichnet, daß zur Vermeidung der Vermischung des Quellmittels und des Ablösemittels sowie weiterer Behandlungsflüssigkeiten Walzen und Wehre gebildet sowie getrennte Behandlungsflüssigkeitskreisläufe gebildet werden.

6. Verfahren nach einem der vorstehenden Ansprüche, dadurch gekennzeichnet, daß die Düsen zum Ablösen der Resistschichten mindestens je einen Druck- und einen Saugbereich aufweisen, wobei die Behandlungsflüssigkeit durch die Bereiche nacheinander gefördert wird.

7. Verfahren nach einem der vorstehenden Ansprüche, dadurch gekennzeichnet, daß zur Herstellung der Behandlungsflüssigkeiten verwendbare Prozeßchemikalien nur in das Quellmittel der ersten Behandlungsstufe dosiert werden.

8. Verfahren nach einem der vorstehenden Ansprüche, dadurch gekennzeichnet, daß das Quellmittel der ersten Behandlungsstufe und das Nachbehandlungsmittel der dritten Behandlungsstufe durch Überlauf so geführt werden, daß sie zur zweiten Behandlungsstufe gelangen.

9. Verfahren nach einem der vorstehenden Ansprüche, dadurch gekennzeichnet, daß die Galvanisiergutoberflächen zum Entfernen der Prozeßchemikalien nach Behandlung in der ersten, zweiten und dritten Behandlungsstufe mit Spülbädern in Form von Kaskaden in Kontakt gebracht werden, wobei die Anzahl der Spülkaskaden so groß gewählt wird, daß die Menge des den Spülkaskaden kontinuierlich zugegebenen Spülwassers den Verlusten der Behandlungsflüssigkeiten in den Behandlungsstufen durch Verdunstung sowie durch Ausschleppung beim Transport des Galvanisiergutes von einer Behandlungsstufe zur nächsten und zu den Spülkaskaden, abzüglich der Menge zudosierter Prozeßchemikalien, entspricht.

10. Verfahren nach einem der vorstehenden Ansprüche, dadurch gekennzeichnet, daß die abgelösten Resist enthaltende Behandlungsflüssigkeit so schnell wie möglich durch Wahl kurzer Förderwege und hoher Strömungsgeschwindigkeiten in den Separator gelangt.

11. Verfahren nach einem der vorstehenden Ansprüche, dadurch gekennzeichnet, daß das Ablösemittel zur Entfernung feinteiliger Resistreste zusätzlich durch einen Feinfilter als Separator geleitet wird.

12. Verfahren nach einem der vorstehenden Ansprüche, dadurch gekennzeichnet, daß der vom Ablösemittel mittels Separator abgetrennte Resist aus dem Separator kontinuierlich oder periodisch mit Spülwasser ausgeschwemmt und einem Filter zur Abtrennung des Spülwassers zugeführt wird, so daß der Resist nach der Abtrennung nahezu trocken und frei von anhaftenden Prozeßchemikalien erhältlich ist.

13. Vorrichtung zum gleichmäßigen chemischen Ablösen von Schichten von Resisten, insbesondere von Photoresisten, in Form leicht filtrierbarer Teilchen von den Oberflächen von plattenförmigem Galvanisiergut, beispielsweise Leiterplatten und Leiterfolien, mittels eines Ablösemittels sowie zum Entfernen des abgelösten Resists aus dem Ablösemittel, insbesondere zur Durchführung des Verfahrens nach einem der vorstehenden Ansprüche, mit
- mehreren hintereinander angeordneten Behandlungsstationen, in denen das Galvanisiergut (7) durch geeignete Transportmittel in horizontaler Lage und horizontaler Richtung in einer Transportebene transportiert werden können,
- geeigneten Verbindungen und Fördermitteln zum Transport der Behandlungsflüssigkeiten und des Spülwassers und
- einem Separator zum Abtrennen des abgelösten Resists von dem Ablösemittel,
dadurch gekennzeichnet, daß die Vorrichtung zur mechanischen Ablösung der Resiste durch Strömung zusätzlich mindestens eine langgestreckte, quer zur Transportrichtung sowie parallel und in geringem Abstand zur Transportebene angeordnete Schwalldüse (12) in mindestens jeder der Behandlungsstufen, in denen die Resistschichten angequollen und abgelöst werden, aufweist.

14. Vorrichtung nach Anspruch 13, dadurch gekennzeichnet, daß die Düsen (12) mit den Schlitzen (5,10) versehene Flächen (6,8) aufweisen, die als konisch sich beidseitig zu den Schlitzen erstreckende Ebenen (6,8) ausgebildet sind, derart, daß sich zwischen den Schlitzen und der Transportebene Aussparungen (6,9)befinden.

15. Vorrichtung nach einem der Ansprüche 13 und 14, gekennzeichnet durch schräggestellte Längsschlitze (5) der Druckkammern (2), die zur Saugkammer (3) hin ausgerichtet sind.

16. Vorrichtung nach einem der Ansprüche 13 bis 15, gekennzeichnet durch zwei Druckkammern (2) und eine zwischen den Druckkammern (2) angeordnete Saugkammer (3).

## Claims

1. Method for the uniform chemical peeling of layers of resists, more especially photosensitive resists, in the form of easily filterable particles from the surfaces of a plate-like article to be electroplated, for example printed circuit boards and conductor foils, by means of a peeling agent, said method also being intended for the removal of the peeled resist from the solvent, having the following essential features:
- conveying the article to be electroplated in a horizontal position and in a horizontal direction through a treatment plant,
- swelling the resist layers by means of a swelling agent as the treatment fluid in a first treatment stage,
- guiding the swelling agent and the peeling agent in a filter circuit, the two agents being largely prevented from mixing by means of a suitable fluid guidance, and
- separating the peeled resist from the peeling agent by means of a separator suitable therefor,
characterised in that the upper side and the lower side of the article to be electroplated are brought into contact with treatment fluids by means of elongate nozzles, which are orientated substantially perpendicularly relative to the direction of conveyance and parallel to the surfaces of the article to be electroplated, in such a manner that the treatment fluids for mechanically peeling the resists by means of flow are conveyed as a fluid surge towards the surfaces of the article to be electroplated.

2. Method according to claim 1, characterised in that the surfaces of the article to be electroplated are subsequently treated by their being completely immersed in water or in a mixture of a solvent with water as the subsequent-treatment agent, in a third treatment stage after the peeling of the resist.

3. Method according to one of the preceding claims, characterised in that the subsequent-treatment agent is conveyed to the surfaces of the article to be electroplated.

4. Method according to claim 1, characterised in that cavitation bubbles are hydrodynamically formed within the subsequent-treatment agent conveyed to the surfaces of the article to be electroplated.

5. Method according to one of the preceding claims, characterised in that, in order to prevent the swelling agent and the peeling agent, as well as additional treatment fluids, from mixing, vortices and weirs are formed, and separate treatment fluid circuits are also formed.

6. Method according to one of the preceding claims, characterised in that the nozzles for peeling the resist layers each have at least one pressure region and one suction region, the treatment fluid being conveyed through the regions successively.

7. Method according to one of the preceding claims, characterised in that process chemicals, which can be used to produce the treatment fluids, are only dosed into the swelling agent of the first treatment stage.

8. Method according to one of the preceding claims, characterised in that the swelling agent of the first treatment stage and the subsequent-treatment agent of the third treatment stage are guided by overflow in such a manner that they pass to the second treatment stage.

9. Method according to one of the preceding claims, characterised in that, in order to remove the process chemicals after treatment in the first, second and third treatment stages, the surfaces of the article to be electroplated are brought into contact with rinsing baths in the form of cascades, the number of the rinsing cascades being selected to be so large that the quantity of the rinsing water, which is continuously added to the rinsing cascades, corresponds to the losses of the treatment fluids in the treatment stages as a result of evaporation and as a result of drag-out during the conveyance of the article to be electroplated from one treatment stage to the next and to the rinsing cascades, minus the quantity of additionally dosed process chemicals.

10. Method according to one of the preceding claims, characterised in that the treatment fluid, containing peeled resist, passes to the separator as rapidly as possible by selecting short paths of conveyance and high flow speeds.

11. Method according to one of the preceding claims, characterised in that the peeling agent for removing finely divided resist residues is additionally conducted through a fine filter as the separator.

12. Method according to one of the preceding claims, characterised in that the resist, which has been separated from the peeling agent by means of the separator, is flushed from the separator with rinsing water continuously or periodically and supplied to a filter for the separation of the rinsing water, so that the resist is almost dry after the separation and is obtainable free of adherent process chemicals.

13. Apparatus for the uniform chemical peeling of layers of resists, more especially photosensitive resists, in the form of easily filterable particles from the surfaces of a plate-like article to be electroplated, for example printed circuit boards and conductor foils, by means of a peeling agent, said apparatus also being intended for removing the peeled resist from the peeling agent, more especially for accomplishing the method according to one of the preceding claims, having
- a plurality of treatment stations, which are disposed one behind the other, and in which the article to be electroplated (7) can be conveyed by suitable conveying means in a horizontal position and in a horizontal direction in a plane of conveyance,
- suitable connections and conveying means for conveying the treatment fluids and the rinsing water, and
- a separator for separating the peeled resist from the peeling agent,
characterised in that the apparatus for mechanically peeling the resists by means of flow additionally has at least one elongate surge nozzle (12) in at least each of the treatment stages, in which the resist layers are swollen and peeled, said nozzle being disposed transversely relative to the direction of conveyance and parallel to the plane of conveyance and at a small spacing therefrom.

14. Apparatus according to claim 13, characterised in that the nozzles (12) have faces (6,8), which are provided with the slots (5,10) and are configured as planes (6,8), which extend conically on each side towards the slots, in such a manner that passages (6,9) are formed between the slots and the plane of conveyance.

15. Apparatus according to one of claims 13 and 14, characterised by inclinedly positioned elongate slots (5) in the pressure chambers (2), which slots are orientated towards the suction chamber (3).

16. Apparatus according to one of claims 13 to 15, characterised by two pressure chambers (2) and one suction chamber (3), which is disposed between the pressure chambers (2).

## Revendications

1. Procédé de détachement chimique uniforme de couches de vernis épargnes, notamment de vernis photosensibles, sous la forme de particules facilement filtrables à partir des surfaces de produits galvanisés en feuilles tels que des circuits imprimés et des films conducteurs au moyen d'un agent de séparation ainsi que d'élimination du verni épargne détaché de l'agent de séparation, présentant les caractéristiques essentielles suivantes :
- transport du produit galvanisé en position horizontale et en direction horizontale dans une installation de traitement ;
- gonflement des couches de vernis épargne au moyen d'un agent gonflant sous la forme d'un liquide de traitement dans une première étape de traitement ;
- passage de l'agent gonflant et de l'agent de séparation dans un circuit de filtration, le mélangeage des deux agents étant substantiellement évité par une circulation appropriée des liquides ; et
- séparation du vernis épargne détaché au moyen d'un séparateur approprié pour cela ;
caractérisé en ce que l'on met en contact la face supérieure et la face inférieure du produit galvanisé avec des liquides de traitement au moyen de buses allongées orientées sensiblement perpendiculairement au sens de transport et parallèlement aux surfaces du produit galvanisé de telle sorte que les liquides de traitement soient transportés contre les surfaces du produit galvanisé par un écoulement en forme de vague de liquide afin de détacher mécaniquement le vernis épargne.

2. Procédé selon la revendication 1, caractérisé en ce que les surfaces du produit galvanisé sont retraitées après séparation du vernis épargne en les plongeant complètement dans de l'eau ou dans un mélange d'un solvant avec de l'eau servant d'agent de retraitement dans une troisième étape de traitement.

3. Procédé selon l'une quelconque des revendications précédentes, caractérisé en ce que l'agent de retraitement est transporté sur les surfaces du produit galvanisé.

4. Procédé selon la revendication 1, caractérisé en ce qu'il se forme des bulles de cavitation hydrodynamique à l'intérieur de l'agent de retraitement transporté sur les surfaces du produit galvanisé.

5. Procédé selon l'une quelconque des revendications précédentes, caractérisé en ce que l'on forme des cylindres et des barrages ainsi que des circuits de liquides de traitement séparés afin d'éviter le mélangeage de l'agent gonflant et de l'agent de séparation ainsi que d'autres liquides de traitement.

6. Procédé selon l'une quelconque des revendications précédentes, caractérisé en ce que les buses de détachement des couches de vernis épargne présentent chacune au moins une zone de compression et une zone d'aspiration, le liquide de traitement étant transporté successivement dans ces zones.

7. Procédé selon l'une quelconque des revendications précédentes, caractérisé en ce que les produits chimiques de processus utilisables pour préparer les liquides de traitement sont dosés uniquement dans l'agent gonflant de la première étape de traitement.

8. Procédé selon l'une quelconque des revendications précédentes, caractérisé en ce que l'on fait circuler l'agent gonflant de la première étape de traitement et l'agent de retraitement de la troisième étape de traitement par débordement de manière à ce qu'ils parviennent dans la deuxième étape de traitement.

9. Procédé selon l'une quelconque des revendications précédentes, caractérisé en ce que, pour éliminer les produits chimiques de processus après traitement dans les première, deuxième et troisième étapes de traitement, on met les surfaces du produit galvanisé en contact avec des bains de rinçage sous la forme de cascades, le nombre de cascades de rinçage étant choisi de telle sorte que la quantité d'eau de rinçage ajoutée en continue aux cascades de rinçage corresponde aux pertes de liquides de traitement par évaporation dans les étapes de traitement et par entraînement lors du transport du produit galvanisé d'une étape de traitement à la suivante et aux cascades de rinçage, moins la quantité de produits de processus rajoutés.

10. Procédé selon l'une quelconque des revendications précédentes, caractérisé en ce que le liquide de traitement contenant le vernis épargne détaché arrive aussi vite que possible dans le séparateur grâce au choix de trajets de transport courts et de vitesses d'écoulement élevées.

11. Procédé selon l'une quelconque des revendications précédentes, caractérisé en ce que l'on fait passer en plus l'agent de séparation dans un filtre fin servant de séparateur afin d'éliminer les résidus de vernis épargne de petite taille.

12. Procédé selon l'une quelconque des revendications précédentes, caractérisé en ce que le vernis épargne séparé de l'agent de séparation au moyen du séparateur est extrait en continu ou par périodes par lavage avec de l'eau de rinçage et amené à un filtre pour séparer l'eau de rinçage, de sorte que le vernis épargne après séparation est presque sec et exempt de produits chimiques de processus adhérents.

13. Dispositif pour détacher chimiquement et uniformément des couches de vernis épargnes, notamment de vernis photosensibles, sous la forme de particules facilement filtrables à partir des surfaces de produits galvanisés en feuilles tels que des circuits imprimés et des films conducteurs au moyen d'un agent de séparation et pour éliminer le vernis épargne détaché de l'agent de séparation, en particulier pour réaliser le procédé selon l'une quelconque des revendications précédentes, comprenant :
- plusieurs postes de traitement disposés les uns à la suite des autres et dans lesquels le produit galvanisé (7) peut être transporté à l'aide de moyens de transport appropriés en position horizontale et en direction horizontale dans un plan de transport ;
- des raccordements et des moyens de convoyage pour le transport des liquides de traitement et de l'eau de rinçage appropriés ; et
- un séparateur pour séparer le vernis épargne détaché de l'agent de séparation ;
caractérisé en ce que le dispositif, pour séparer mécaniquement les vernis épargnes par écoulement, présente au moins une buse à vague (12) allongée disposée perpendiculairement à la direction de transport et parallèlement au plan de transport et à une faible distance de ce dernier dans au moins chacune des étapes de traitement dans lesquelles les couches de vernis épargne sont gonflées et détachées.

14. Dispositif selon la revendication 13, caractérisé en ce que les buses (12) présentent des surfaces (6, 8) munies de fentes (5, 10) sous la forme de plans (6, 8) qui s'étendent de manière conique des deux côtés vers les fentes, de sorte que des dégagements (6, 9) se trouvent entre les fentes et le plan de transport.

15. Dispositif selon la revendication 13 et la revendication 14, caractérisé en ce que les chambres de compression (2) présentent des fentes longitudinales obliques (5) orientées en direction de la chambre d'aspiration (3).

16. Dispositif selon l'une quelconque des revendications 13 à 15, caractérisé en ce qu'il comprend deux chambres de compression (2) et une chambre d'aspiration (3) disposée entre les chambres de compression (2).
